Europäisches Patentamt

European Patent Office

Office européen des brevets

(19)

(11) Veröffentlichungsnummer: **0 056 430**
**A2**

(12) # EUROPÄISCHE PATENTANMELDUNG

(21) Anmeldenummer: 81108323.7

(22) Anmeldetag: 14.10.81

(51) Int. Cl.³: **G 01 R 13/40**

(30) Priorität: 19.01.81 DE 3101458

(43) Veröffentlichungstag der Anmeldung:
28.07.82 Patentblatt 82/30

(84) Benannte Vertragsstaaten:
DE FR GB IT

(71) Anmelder: SIEMENS AKTIENGESELLSCHAFT Berlin
und München
Postfach 22 02 61
D-8000 München 22(DE)

(72) Erfinder: Walter, Karl-Heinz, Dipl.-Ing.
Herzog-Heinrich-Strasse 13
D-8018 Grafing(DE)

(54) **Verfahren zum Ansteuern einer auflaufenden Flüssigkristall-Bandanzeige.**

(57) Bei auflaufenden Flüssigkristall (FK)-Bandanzeigen gibt es drei FK-Gruppen: Solche, bei denen alle FK-Zellen eingeschaltet sind, solche, bei denen alle FK-Zellen ausgeschaltet sind und eine, bei der ein Teil der FK-Zellen ein- und ein Teil ausgeschaltet ist. Bei der Matrixadressierung sind somit für die Spaltenleiter Dreifach-Umschalter notwendig, die mit handelsüblichen Umschaltern nur mit großem Aufwand zu realisieren sind. Die Erfindung besteht darin, nur zwei Spalten-Ansteuerleitungen (21, 22) zu verwenden. Diese führen Impulse, deren Spannungswerte 0 und 2u beziehungsweise 2u und 4u betragen. Zwischen beiden Ansteuerleitungen wird mindestens einmal pro Bildperiode durch Schalter (16, 17, 18) umgeschaltet. Die Zeilenleiter (7, 8) führen Spannungen mit den Effektivwerten u, 2u, 3u. Die Erfindung wird angewendet bei FK-Bandanzeigen mit Matrixadressierung.

FIG 3

0056430

SIEMENS AKTIENGESELLSCHAFT       Unser Zeichen
Berlin und München               VPA 81 P 1 0 0 4 E

Verfahren zum Ansteuern einer auflaufenden Flüssigkri-
stall-Bandanzeige

Die Erfindung bezieht sich auf ein Verfahren zum Ansteuern einer auflaufenden Flüssigkristall(FK)-Bandanzeige
durch Matrixadressierung, mit zwei Gruppen von Zeilenleitern und mit mindestens drei Spaltenleitern, die jeweils mit mindestens zwei hintereinanderliegenden FK-
Zellen elektrisch verbunden sind, durch Umschalten der
Zeilen- und Spaltenleiter auf Zeilen- beziehungsweise
Spalten-Ansteuerleitungen, die solche periodisch wiederkehrende, miteinander synchronisierte Spannungen führen,
die zusammen die zum Ein- und Ausschalten der FK-Zellen
notwendigen Spannungen ergeben.

Ein solches Verfahren ist zum Beispiel in einem Artikel
von A. R. Kmetz: "A Twisted Nematic Dual Bargraph System", SID 77 Digest, Seite 58 und 59 beschrieben worden.
Beim Betrieb einer solchen FK-Bandanzeige lassen sich
drei Gruppen von FK-Zellen unterscheiden: Zur ersten
Gruppe gehören diejenigen FK-Zellen, bei der alle ein
und derselben Rückelektrode zugeordneten Zellen eingeschaltet sind. Zur zweiten Gruppe gehören diejenigen
FK-Zellen, bei der alle ein und derselben Rückelektrode
zugeordneten FK-Zellen ausgeschaltet sind. Die dritte
Gruppe enthält sowohl eingeschaltete als auch ausgeschaltete FK-Zellen. Bei der Matrixadressierung sind
daher mindestens drei Spaltenleiter notwendig, die entsprechend dem Zustand vollständig eingeschaltet, vollständig ausgeschaltet oder gemischt eingeschaltet mit
drei unterschiedlichen Wechselspannungen zu versorgen

Hab 1 Dx / 14.01.1981

sind. Das bedeutet, daß für jeden Spaltenleiter entweder ein Dreifach-Analogumschalter oder wie in der oben genannten Literaturstelle ein kompliziertes System von Ein-Ausschaltern notwendig ist.

Der Erfindung liegt die Aufgabe zugrunde, das Verfahren der eingangs genannten Art so weiterzubilden, daß zum Speisen der Spaltenleiter jeweils ein einfacher Umschalter ausreicht. Dabei soll ein möglichst hohes Verhältnis der Spannungen von eingeschaltetem Zustand zu ausgeschaltetem Zustand erzielt werden.

Die Erfindung ist dadurch gekennzeichnet, daß lediglich zwei Spalten-Ansteuerleitungen vorgesehen sind, daß jeder der Spaltenleiter über je einen Umschalter mit einer der Spalten-Ansteuerleitungen verbunden wird, daß in die erste Spalten-Ansteuerleitung ein Impulszug mit den Spannungswerten 2u und 4u eingespeist wird, daß in die zweite Spalten-Ansteuerleitung ein Impulszug mit den Spannungswerten 0 und 2u eingespeist wird, und daß die Umschalter pro Bildperiode mindestens einmal umgeschaltet werden.

Weiterbildungen der Erfindung sind Gegenstand der Unteransprüche.

Die Erfindung wird an Hand eines Ausführungsbeispiels in Verbindung mit den Fig. 1 bis 6 näher erläutert. Es zeigen:

Fig. 1 das Prinzipschaltbild einer auflaufenden FK-Bandanzeige,

Fig. 2 ein Schaltungsdiagramm zur Durchführung des Verfahrens nach dem Stand der Technik,

Fig. 3 ein Schaltungsdiagramm zur Durchführung des Verfahrens nach der Erfindung,

Fig. 4 den Impulsverlauf an den Spalten-Ansteuerleitungen,

Fig. 5 eine Tabelle mit logischen Symbolen für die Schalterstellungen der Anordnung nach Fig. 3,

Fig. 6 die Impulsformen auf den Spaltenleitern, den Zeilenleitern und die daraus resultierenden Spannungen an den FK-Zellen.

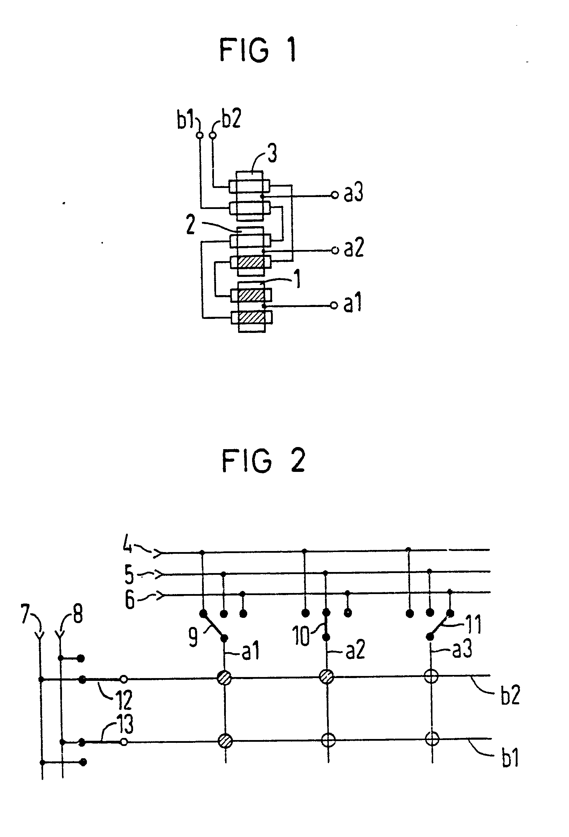

In Fig. 1 ist eine FK-Anzeige mit drei Gruppen von FK-Zellen dargestellt. Sie wird von zwei Zeilenleitern b1 und b2 und von Spaltenleitern a1, a2 und a3 angesteuert. Die Zeilenleiter sind jeweils einer FK-Zelle in jeder Gruppe gemeinsam. Sie sind jeweils mit einer Elektrode dieser FK-Zellen verbunden. Die anderen Elektroden der FK-Zellen sind jeweils gruppenweise mit einer der Spaltenleiter verbunden. Bei der dargestellten Bandanzeige sind alle FK-Zellen der Gruppe 1 eingeschaltet, dagegen nur ein Teil der FK-Zellen der Gruppe 2 und keine der FK-Zellen der Gruppe 3. Den Zeilenleitern und den Spaltenleitern müssen also Spannungen zugeführt werden, durch die diese drei Zustände einstellbar sind.

In Fig. 2 ist das Bild, das die Bandanzeige nach Fig. 1 zeigt, in einem Schaltschema dargestellt. Es sind drei Spalten-Ansteuerleitungen 4, 5, 6 vorgesehen, mit denen die Spaltenleiter a1, a2 und a3 über Dreifach-Umschalter 9, 10, 11 verbindbar sind. Die Zeilenleiter b1 und b2 sind über einfache Umschalter 12, 13 mit Zeilen-Ansteuerleitungen 7, 8 verbindbar. Auf die genannten Leiter wird jeweils eine Wechselspannung mit einem definierten Effektivwert gegeben, wobei die Spalten-Ansteuerleitung 4 den höchsten, die Spalten-Ansteuerleitung 5 einen mittleren und die Spalten-Ansteuerleitung 6 den niedrigsten Effektivwert hat. Werden auf die Zeilen-Ansteuerleitungen 7, 8 noch entsprechende Wechselspannungen gegeben, so läßt sich durch entsprechende Adressierung der einzelnen Spalten- und Zeilenleiter jedes beliebige Bild einstellen. Dies erfordert jedoch, wie bereits eingangs erwähnt, Dreifach-Umschalter für die Spaltenleiter.

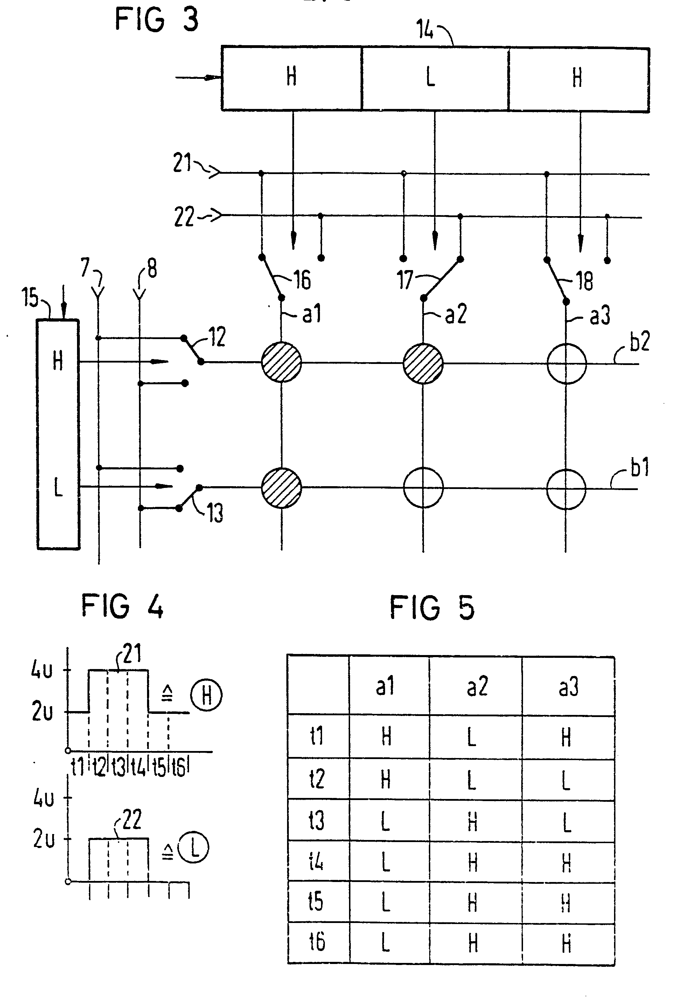

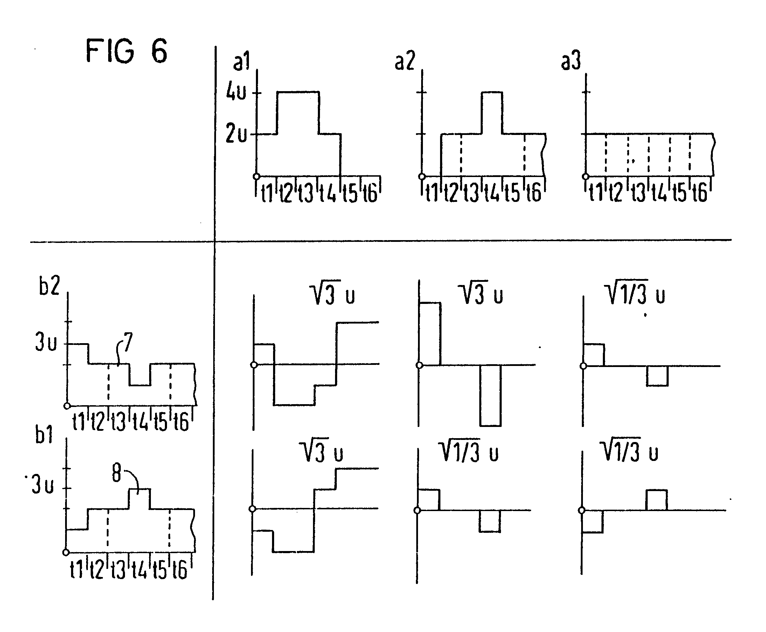

In Fig. 3 ist das gleiche Bild wie in Fig. 2 beziehungsweise Fig. 1 verwirklicht. Die Spaltenleiter a1, a2 und a3 sind über einfache Umschalter 16, 17, 18 an zwei Spalten-Ansteuerleitungen 21, 22 gelegt. Die Zeilenleiter b1 und b2 liegen über die Umschalter 12, 13 an den Zeilen-Ansteuerleitungen 7, 8. Die Schalter werden durch Steuerungen 14, 15 betätigt, die zum Beispiel Schieberegister sein können. Zur Erläuterung der Funktionsweise sei vereinbart, daß die Schalter für die Spaltenleiter beim Pegel H (High) auf die Spalten-Ansteuerleitung 21 und beim Pegel L (Low) auf die Spalten-Ansteuerleitung 22 geschaltet werden. Die Schalter 12 und 13 sollen bei Pegel H auf die Zeilen-Ansteuerleitung 7 und beim Pegel L auf die Zeilen-Ansteuerleitung 8 geschaltet werden. Auf die Ansteuerleitungen 7, 8, 21, 22 werden Impulszüge gegeben, deren Formen an Hand der Fig. 4 und 6 erläutert werden.

In Fig. 4 ist dargestellt, wie die Impulsformen auf den Spalten-Ansteuerleitungen 21 und 22 aussehen. Diese Impulse sind in sechs gleichmäßige zeitliche Abschnitte t1 ... t6 eingeteilt. Die Impulsform auf der Leitung 21 läßt sich daher beschreiben mit 2u . t, 4u . 3t, 2u . 2t. Sie bedeutet Pegel H. Die Impulsform auf der Leitung 22 läßt sich beschreiben mit 0 . t, 2u . 3t, 0 . 2t. Sie bedeutet Pegel L. Die Impulsformen auf den Zeilen-Ansteuerleitungen 7 und 8 sind ebenfalls in sechs gleiche Zeitabschnitte eingeteilt. Der Impulszug auf der Leitung 7 läßt sich beschreiben mit 3u . t, 2u . 2t, u . t, 2u . 2t. Der Impulszug auf der Leitung 8 läßt sich beschreiben mit u . t, 2u . 2t, 3u . t, 2u . 2t. Zur Erzeugung der Wechselspannungen auf den Spaltenleitern a1, a2 und a3 werden die Schalter 16, 17 und 18 in jeder Impulsperiode mindestens einmal umgeschaltet. Zur Darstellung des Bildes nach Fig. 3 wird das logische Schema nach Fig. 5 zugrunde gelegt. Man sieht, daß der Spaltenleiter a1 zur Zeit t1 und t2 den Pegel H und zur Zeit t3 bis t6 den Pegel L hat. Hier ist also innerhalb der Bildperiode ein einmaliges Umschalten erforderlich. Der Spaltenleiter a2 hat zur Zeit t1 und t2 die Werte L und zur Zeit t3 bis t6 den Wert H. Der Schalter 17 muß daher ebenfalls lediglich einmal innerhalb der Bildperiode umgeschaltet werden. Lediglich der dem Spaltenleiter a3 zugeordnete Schalter 18 wird zweimal innerhalb der Bildperiode umgeschaltet, wie sich aus der rechten Spalte des logischen Schemas nach Fig. 5 ergibt. Wird der in Fig. 5 gezeigte logische Ablauf zum Beispiel durch entsprechende Programmierung der Steuerung 14 eingestellt, so ergeben sich die in Fig. 6 dargestellten Spannungsverläufe auf den Spaltenleitern a1, a2 und a3. Die den Zeilenleitern b1 und b2 zugeordneten Schalter 12 und 13 werden innerhalb der Bildperiode, das heißt von t1 bis t6 nicht umgeschaltet.

Die in Fig. 6 dargestellten Spannungen auf den Zeilen- und Spaltenleitern ergeben in den FK-Zellen Spannungsdifferenzen, durch die die adressierten FK-Zellen entweder eingeschaltet oder ausgeschaltet sind. Für die eingeschalteten FK-Zellen an den Schnittpunkten von a1/b1, a1/b2, a2/b1 ergeben sich Effektivwerte der anliegenden Spannungsdifferenzen von $\sqrt{3} \cdot u$. Dabei ist u diejenige Spannung, die mindestens erforderlich ist, um die FK-Zelle einzuschalten. Für die ausgeschalteten restlichen Zellen ergibt sich eine Spannungsdifferenz von $\sqrt{1/3} \cdot u$. Damit liegt diese Spannung sicher unter derjenigen Spannung, bei der die FK-Zelle anzeigt. Als Ein-Ausschalt-Verhältnis ergibt sich

$$\frac{\sqrt{3}}{\sqrt{1/3}} = 3$$

Damit wird ein guter Kontrast erzielt.

Das Verfahren wurde für den Fall erläutert, daß die Ansteuerung der Spalten gleichzeitig erfolgt. Der erzielte Bildkontrast reicht jedoch aus, um eine spaltensequentielle Ansteuerung (Multiplexverfahren) durchführen zu können.

6 Figuren

3 Patentansprüche

<u>Patentansprüche</u>

1. Verfahren zum Ansteuern einer auflaufenden Flüssigkristall(FK)-Bandanzeige durch Matrixadressierung, mit zwei Gruppen von Zeilenleitern und mit mindestens drei Spaltenleitern, die jeweils mit mindestens zwei hintereinanderliegenden FK-Zellen elektrisch verbunden sind, durch Umschalten der Zeilen- und Spaltenleiter auf Zeilen- beziehungsweise Spalten-Ansteuerleitungen, die solche periodisch wiederkehrende, miteinander synchronisierte Spannungen führen, die zusammen die zum Ein- und Ausschalten der FK-Zellen notwendigen Spannungen erge-ben, d a d u r c h   g e k e n n z e i c h n e t , daß lediglich zwei Spalten-Ansteuerleitungen (21, 22) vorgesehen sind, daß jeder der Spaltenleiter (a1, a2, a3) über je einen Umschalter (16, 17, 18) mit einer der Spalten-Ansteuerleitungen verbunden wird, daß in die erste Spalten-Ansteuerleitung (21) ein Impulszug mit den Spannungswerten 2u und 4u eingespeist wird, daß in die zweite Spalten-Ansteuerleitung (22) ein Impulszug mit den Spannungswerten 0 und 2u eingespeist wird, und daß die Umschalter pro Bildperiode mindestens einmal umgeschaltet werden.

2. Verfahren nach Anspruch 1, d a d u r c h   g e -k e n n z e i c h n e t ,   daß in die Zeilen-Ansteuerleitungen (b1, b2) je ein Impulszug eingespeist wird, der die Spannungswerte u, 2u und 3u aufweist.

3. Verfahren nach Anspruch 1 und 2, d a d u r c h g e k e n n z e i c h n e t ,   daß die Impulszüge je in sechs gleiche Zeitabschnitte (t1 ... t6) eingeteilt sind, daß der Impulszug auf der ersten Spalten-Ansteuerleitung den Verlauf 2u . t, 4u . 3t, 2u . 2t hat, daß der Impulszug auf der zweiten Spalten-Ansteuerleitung den Verlauf 0 . t, 2u . 3t, 0 . 2t hat, daß der Impulszug auf der ersten Zeilen-Ansteuerleitung den Verlauf
3u . t, 2u . 2t, u . t, 2u . 2t hat und daß der Impulszug auf der zweiten Zeilen-Ansteuerleitung den Verlauf
u . t, 2u . 2t, 3u . t, 2u . 2t hat.

1/3

FIG 1

FIG 2

FIG 3

FIG 4

FIG 5

| | a1 | a2 | a3 |
|----|----|----|----|
| t1 | H | L | H |
| t2 | H | L | L |
| t3 | L | H | L |
| t4 | L | H | H |
| t5 | L | H | H |
| t6 | L | H | H |

FIG 6

a1
4υ
2υ
t1 t2 t3 t4 t5 t6

a2
t1 t2 t3 t4 t5 t6

a3
t1 t2 t3 t4 t5 t6

b2
3υ
7
t1 t2 t3 t4 t5 t6

b1
3υ
8
t1 t2 t3 t4 t5 t6

√3 υ

√3 υ

√1/3 υ

√3 υ

√1/3 υ

√1/3 υ